(19) Europäisches Patentamt
European Patent Office
Office européen des brevets

(11) Veröffentlichungsnummer: **0 372 408 B1**

(12) **EUROPÄISCHE PATENTSCHRIFT**

(45) Veröffentlichungstag der Patentschrift: **08.06.94**

(51) Int. Cl.⁵: **G03F 7/004**

(21) Anmeldenummer: **89122182.2**

(22) Anmeldetag: **01.12.89**

# (54) Strahlungsempfindliches Gemisch.

(30) Priorität: **09.12.88 DE 3841437**

(43) Veröffentlichungstag der Anmeldung:
**13.06.90 Patentblatt 90/24**

(45) Bekanntmachung des Hinweises auf die Patenterteilung:
**08.06.94 Patentblatt 94/23**

(84) Benannte Vertragsstaaten:
**BE DE FR GB IT NL**

(56) Entgegenhaltungen:
**EP-A- 0 153 682**
**EP-A- 0 202 196**

(73) Patentinhaber: **BASF Aktiengesellschaft**
**Carl-Bosch-Strasse 38**
**D-67063 Ludwigshafen(DE)**

(72) Erfinder: **Nguyen Kim, Son, Dr.**
**Leipziger Strasse 43**
**D-6842 Buerstadt(DE)**
Erfinder: **Hoffmann, Gerhard, Dr.**
**Pappelstrasse 22**
**D-6701 Otterstadt(DE)**
Erfinder: **Schwalm, Reinhold, Dr.**
**Am Huettenwingert 53**
**D-6706 Wachenheim(DE)**
Erfinder: **Binder, Horst**
**Haendelstrasse 3**
**D-6840 Lampertheim(DE)**
Erfinder: **Schuhmacher, Rudolf, Dr.**
**Schulgaesschen 4**
**D-6737 Boehl-Iggelheim(DE)**

EP 0 372 408 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft positiv arbeitende strahlungsempfindliche Gemische, die ein in Wasser unlösliches, in wäßrig-alkalischen Lösungen lösliches Bindemittel, eine unter Einwirkung von Strahlung eine Säure bildende Verbindung und eine organische Verbindung, die durch säurekatalytische Einwirkung verseift und decarboxyliert wird, wodurch die Alkalilöslichkeit des Gemisches erhöht wird, enthalten. Diese Gemische sind sensitiv gegenüber UV-, Elektronen- und Röntgenstrahlen und eignen sich besonders als Resistmaterial.

Positiv arbeitende strahlungsempfindliche Gemische sind bekannt und besonders positiv arbeitende Resistmaterialien, die o-Chinondiazide in wäßrig-alkalisch löslichen Bindemitteln, z.B. Novolaken oder Poly-(p-vinylphenol)en, enthalten, werden kommerziell eingesetzt. Die Empfindlichkeit dieser Systeme gegenüber Strahlung, insbesondere kurzwelliger Strahlung, ist jedoch teilweise unbefriedigend.

Empfindlichkeitserhöhungen in strahlungsempfindlichen Systemen, die in der Primärphotoreaktion eine Spezies erzeugen, die dann unabhängig von der Strahlung eine katalytische Sekundärreaktion auslöst, sind beschrieben. So sind in der US-A 3,915,706 beispielsweise Photoinitiatoren beschrieben, die eine starke Säure erzeugen, die dann in einer Sekundärreaktion Säurelabile Gruppen, wie Polyaldehydgruppierungen spalten.

Weiterhin sind strahlungsempfindliche Gemische auf Basis von säurespaltbaren Verbindungen bekannt, die als Bindemittel ein wäßrig-alkalisch lösliches Polymer sowie eine Verbindung, die photochemisch eine starke Säure bildet, und eine weitere Verbindung mit durch Säure spaltbaren Bindungen, die durch die Einwirkung der Säure ihre Löslichkeit in einem alkalischen Entwickler erhöhen, enthalten (vgl. DE-A 3 406 927). Als photochemisch eine starke Säure bildende Verbindungen werden Diazonium-, Phosphonium-, Sulfonium- und Iodonium-, sowie Halogenverbindungen genannt. Die Verwendung dieser Oniumsalze als photochemische Säurespender in Resistmaterialien ist z.B. auch aus US-A 4,491,628 bekannt. Einen Überblick über die Anwendung von Oniumsalzen in Resistmaterialien gibt Crivello in Org. Coatings and Appl. Polym. Sci., 48, p. 65-69 (1985).

Strahlungsempfindliche Gemische von Polymeren mit säurelabilen Seitengruppen und photochemischen Säurespendern sind z.B. aus US-A 4,491,628 und FR-A 2,570,844 bekannt. Diese polymeren Bindemittel sind jedoch hydrophob und werden erst nach der Belichtung alkalilöslich.

Copolymere mit phenolischen und säurelabilen Gruppen, wie beispielsweise Poly-(p-hydroxistyrol-co-t-butoxicarbonyloxistyrol), sind aus J. Polym. Sci., Part A, Polym. Chem. Ed., Vol. 24, 2971-2980 (1986) bekannt. Verwendet man jedoch diejenigen Copolymeren dieser Gruppe, die noch alkalilöslich sind, in Verbindung mit den kommerziellen Sulfoniumsalzen, wie Triphenylsulfoniumhexafluoroarsenat, wie auch in US-A 4,491,628 beschrieben, so haben diese Gemische den Nachteil, daß ein sehr hoher Abtrag der unbelichteten Bereiche stattfindet, da die genannten Sulfoniumsalze nicht genügend zur Löslichkeitsinhibierung beitragen. Weiterhin tragen diese Salze nach der Belichtung nicht zu einer Löslichkeitserhöhung der bestrahlten Bereiche in alkalischen Entwicklern bei, da keine alkalilöslichen Photoprodukte entstehen.

In der DE-A 37 21 741 werden strahlungsempfindliche Gemische beschrieben, die ein in wäßrig-alkalischen Lösungen lösliches polymeres Bindemittel enthalten sowie eine organische Verbindung, deren Löslichkeit in einem wäßrig-alkalischen Entwickler durch Einwirkung von Säure erhöht wird und die mindestens eine durch Säure spaltbare Gruppierung enthält, wobei diese organische Verbindung unter Einwirkung von Strahlung eine starke Säure erzeugt.

Aufgabe der vorliegenden Erfindung ist es, neue positiv arbeitende hochaktive strahlungsempfindliche Systeme für die Herstellung von Reliefstrukturen aufzuzeigen, die sich mit wäßrig-alkalischen Lösungen entwickeln lassen und die Herstellung von im kurzwelligen UV lichtempfindlichen Schichten ermöglichen.

Dazu soll ein strahlungsempfindliches Gemisch, das ein in Wasser unlösliches, in wäßrig-alkalischer Lösung lösliches Bindemittel, eine säurelabile organische Verbindung, die durch Einwirkung von Säure verseift und bei erhöhter Temperatur decarboxyliert wird, und eine bei Bestrahlung eine starke Säure bildende Verbindung enthält, bildmäßig bestrahlt, erwärmt und die bildmäßig bestrahlten Schichtbereiche mit Entwicklerlösung ausgewaschen werden.

Überraschenderweise wurde gefunden, daß durch den Einsatz von Monoketalen von $\beta$-Dicarbonylverbindungen als die Löslichkeit der Bindemittel in wäßrig-alkalischen Lösungen inhibierenden Verbindungen hochaktive strahlungsempfindliche Systeme für die Herstellung von Reliefstrukturen im kurzwelligen UV erhalten werden, die sich besonders durch sehr gute Reproduzierbarkeit und hohe Auflösung, besonders in Kombination mit Bindemitteln auf Novolak-Basis auszeichnen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch,

(b) einer bei Bestrahlung eine starke Säure bildenden Verbindung und

(c) einer oder mehreren die Löslichkeit von (a) in wäßrig-alkalischen Lösungen inhibierenden organischen Verbindungen,

das dadurch gekennzeichnet ist, daß die organische Verbindung (c) ein Monoketal einer $\beta$-Dicarbonylverbindung der allgemeinen Formel (I)

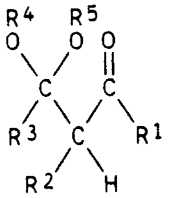

(I)

ist, worin

| | |
|---|---|
| $R^1$ und $R^3$ | untereinander gleich oder verschieden sind und für Alkyl, Cycloalkyl, Aralkyl, gegebenenfalls alkyl- oder halogensubstituiertes, Aryl stehen, |
| $R^2$ = | Wasserstoff, Halogen, Alkyl, Cycloalkyl, Aralkyl, gegebenenfalls alkyl- oder halogensubstituiertes, Aryl, |

oder $R^1$ zusammen mit $R^2$, $R^1$ zusammen mit $R^3$ oder $R^2$ zusammen mit $R^3$ einen fünf- oder sechsgliedrigen Ring bilden,

$R^4$ und $R^5$ untereinander gleich oder verschieden sind und für Alkyl, Cycloakyl oder Aralkyl stehen, oder $R^4$ und $R^5$ zusammen einen fünf- oder sechsgliedrigen Ring bilden.

Das strahlungsempfindliche Gemisch kann als Bindemittel (a) ein phenolisches Harz, wie beispielsweise Novolake mit mittleren Molekulargewichten $\overline{M}_n$ zwischen 300 und 20 000, Copolymerisate aus p-Hydroxystyrol und p-tert.-Butoxycarbonyloxistyrol, Copolymerisate aus p-Hydroxystyrol und Alkoxystyrol sowie Copolymerisate aus p-Hydroxystyrol und 2-Tetrahydropyranyloxistyrol oder deren Gemische enthalten.

Bevorzugt als bei Bestrahlung eine starke "Säure bildende" Verbindungen (b) sind Sulfoniumsalze der allgemeinen Formel (II)

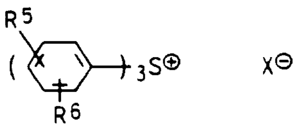

(II)

und Jodoniumsalze der allgemeinen Formel (III)

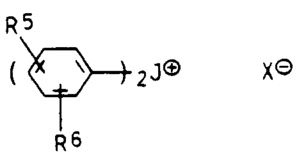

(III),

worin $R^5$ und $R^6$ untereinander gleich oder verschieden sind und für H, OH oder einen der Reste

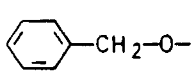

,

($C_1$- bis $C_4$-Alkyl)$_3$Si-O- ,

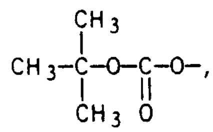

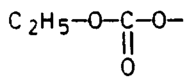 oder 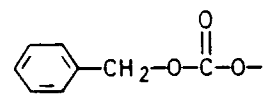

stehen und $X^{\ominus}$ = $Cl^{\ominus}$, $Br^{\ominus}$, $ClO_4^{\ominus}$, Hexafluoroarsenat, Hexafluoroantimonat, Hexafluorophosphat und/oder Tetrafluoroborat ist.

Bevorzugt sind als Komponente (c) die Monoketale folgender β-Dicarbonylverbindungen: 1,3-Cyclopentandion, 1,3-Cyclohexandion, Dimedon, Indandion und Benzoylaceton.

Gegenstand der vorliegenden Erfindung ist auch ein Verfahren zur Herstellung von Reliefstrukturen oder zur Strukturierung von Wafern durch Auftragen von Photoresistlösungen in einer Schichtdicke von 0,1 bis 5 µm auf ein in üblicher Weise vorbehandeltes Substrat, Trocknen, bildmäßige Belichtung, gegebenenfalls Erhitzen auf Temperaturen von bis zu 150 °C, und Entwickeln mit einer wäßrig-alkalischen Lösung, wobei Photoresistlösungen eingesetzt werden, die erfindungsgemäße strahlungsempfindliche Gemische enthalten.

Das erfindungsgemäße System ist besonders vorteilhaft, da es sich in Kombination mit den besonders preisgünstigen Bindemitteln auf Novolak-Basis einsetzen läßt. Die damit erhaltenen Reliefstrukturen zeichnen sich durch sehr gute Reproduzierbarkeit und hohe Auflösung aus.

Zu den Aufbaukomponenten des erfindungsgemäßen strahlungsempfindlichen Gemisches ist im einzelnen folgendes auszuführen.

a) Als in Wasser unlösliche, in wäßrig-alkalischen Lösungen lösliche Bindemittel oder Bindemittelgemische kommen wegen der meist erforderlichen Plasmaätzstabilität im allgemeinen phenolische Harze in Betracht, wie z.B. Novolake mit Molekulargewichten $\overline{M}_n$ zwischen 200 und 20.000, vorzugsweise zwischen 300 und 2000 g/mol, für Belichtung im kurzwelligen UV-Bereich (≦ 300 nm) insbesondere Novolake auf Basis p-Kresol/Formaldehyd, Poly(p-hydroxystyrole), Poly(p-hydroxy-α-methylstyrole), wobei diese Poly(p-hydroxystyrole) im allgemeinen Molekulargewichte $\overline{M}_n$ zwischen 200 und 100.000, vorzugsweise zwischen 1000 und 40.000 g/mol aufweisen, wobei diese Poly(p-hydroxystyrole) auch in bekannter Weise durch Umsetzung (polymeranaloge Umsetzung) ihrer Hydroxylgruppen mit z.B. Chloressigsäure, Chloressigsäureester, Alkylhalogenid, Benzylhalogenid, 3,4-Dihydropyran, Dihydrofuran, Chlorkohlensäureester und/oder Pyrokohlensäureester modifiziert sein können. Die so erhältlichen und im vorliegenden Falle auch als Copolymerisate verstandenen modifizierten polymeren Bindemittel (a) sind beispielsweise solche aus p-Hydroxystyrol und p-tert.-Butoxycarbonyloxistyrol, p-Hydroxystyrol und Alkoxystyrol, p-Hydroxystyrol und 2-Tetrahydropyranyloxistyrol. Bevorzugte Copolymere von p-Hydroxystyrol, die seitenständige Schutzgruppen enthalten, enthalten im wesentlichen Gruppierungen der Formel

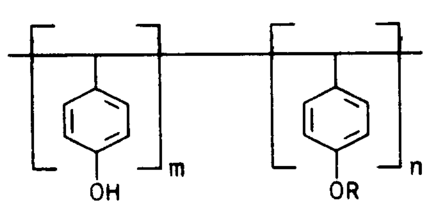

worin n ≦ m und

R = 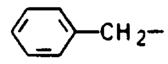 , 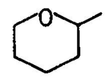 , 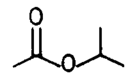 , 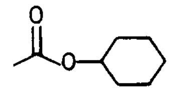 ,

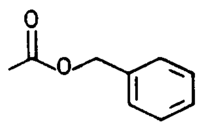 , 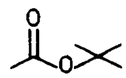 , 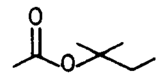

d.h. Copolymere mit p-Benzyl-oxistyrol-, p-(2-Tetrahydropyranyl)-oxistyrol-, p-(iso-Propyl-oxicarbonyl)-oxistyrol-, p-(Cyclohexyl-oxicarbonyl)-oxistyrol-, p-(Benzyloxicarbonyl)-oxistyrol-, p-(t.Butyloxicarbonyl)-oxistyrol- und/oder p-(t.Pentyloxicarbonyl)-oxistyroleinheiten.

Es eignen sich auch Gemische der obengenannten Bindemittel (a) . Bindemittel (a) ist im erfindungsgemäßen Gemisch im allgemeinen in Mengen von 45 bis 95, vorzugsweise 80 bis 90 Gew.%, bezogen auf die Gesamtmenge des strahlungsempfindlichen Gemisches (a) + (b) + (c) enthalten.

b) Als bei Bestrahlung eine starke Säure bildende Verbindungen (b) kommen im Prinzip alle Verbindungen in Frage, die diese Eigenschaft aufweisen und so als Säurespender wirksam sind. Für die Bestrahlung mit kurzwelligen UV-Strahlen sind jedoch Iodonium- und insbesondere Sulfoniumsalze bevorzugt. Diese entsprechen den allgemeinen Formeln (II) bzw. (III)

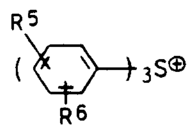 $X^{\ominus}$ (II)

bzw.

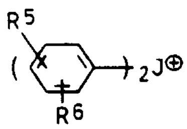 $X^{\ominus}$ (III),

worin

$R^5$ und $R^6$ untereinander gleich oder verschieden sind und für H (Triphenylsulfoniumsalz bzw. Diphenyliodoniumsalz), OH,

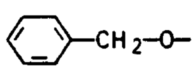

d.h. Tris(4-benzyloxiphenyl)-sulfoniumsalz,

($C_1$- bis $C_4$-Alkyl)$_3$Si-O- d.h. Tris(trimethylsilyloxyphenyl)sulfoniumsalz,

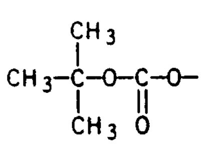

d.h. Tris(4-tert.-butoxicarbonyloxiphenyl)sulfoniumsalz,

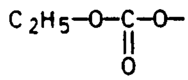

d.h. Tris(4-ethyloxicarbonyloxiphenyl)sulfoniumsalz),

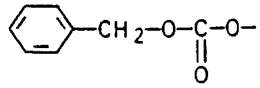

d.h. Tris(4-benzylcarbonyloxiphenyl)-sulfoniumsalz

$X^{\ominus}$ = $Cl^{\ominus}$, $Br^{\ominus}$, $ClO_4^{\ominus}$, $AsF_6^{\ominus}$, $PF_6^{\ominus}$, $SbF_6^{\ominus}$ und/oder $BF_4^{\ominus}$.

Auch Gemische der unter (b) genannten Verbindungen können eingesetzt werden. Komponente (b) ist im erfindungsgemäßen strahlungsempfindlichen Gemisch im allgemeinen in Mengen von 0,1 bis 20, vorzugsweise 2 bis 10 Gew.%, bezogen auf die Gesamtmenge des strahlungsempfindlichen Gemisches (a) + (b) + (c) enthalten.

c) Als die Löslichkeit des Bindemittels (a) inhibierende organische Verbindung (c) werden erfindungsgemäß Monoketale von ß-Dicarbonylverbindungen der allgemeinen Formel (I) eingesetzt,

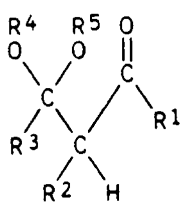

(I)

ist, worin

$R^1$ und $R^3$ untereinander gleich oder verschieden sind und für Alkyl, beispielsweise n-Alkyl mit 1 bis 8 Kohlenstoffatomen, wie Methyl, Ethyl, n-Propyl und n-Butyl, sek.Alkyl mit 3 bis 8 Kohlenstoffatomen, wie Isopropyl, Isobutyl und Isoamyl, tert.-Alkyl mit 4 bis 5 Kohlenstoffatomen, wie tert.-Butyl und tert.-Amyl, Cycloalkyl, z.B. Cyclohexyl, Aralkyl mit 1 bis 2 Kohlenstoffatomen in der Alkylgruppe, wie Benzyl, halogensubstituiertes Aralkyl, z.B. p-Chlorbenzyl, Aryl, wie z.B. Phenyl, alkylsubstituiertes Aryl, wie Tolyl, alkoxysubstituiertes Aryl, wie Methoxyphenyl, halogen-(wie z.B. F, Cl, Br, J, vorzugsweise Cl, Br)-substituiertes Aryl, insbesondere Phenyl, wie z.B. p-Chlorphenyl, stehen;

$R^2$ = Wasserstoff, Halogen, wie z.B. Chlor oder Brom, Alkyl, beispielsweise n-Alkyl mit 1 bis 8 Kohlenstoffatomen, wie Methyl, Ethyl, n-Propyl, n-Butyl, sek.Alkyl mit 3 bis 8 Kohlenstoffatomen, wie Isopropyl, Isobutyl und Isoamyl, tert.-Alkyl mit 4 bis 5 Kohlenstoffatomen, wie tert.-Butyl und tert.-Amyl, Cycloalkyl, z.B. Cyclohexyl, Aralkyl mit 1 bis 2 Kohlenstoffatomen in der Alkylgruppe, wie Benzyl, halogensubstituiertes Aralkyl, z.B. p-Chlorbenzyl, Aryl, wie z.B. Phenyl, alkylsubstituiertes Aryl, wie Tolyl, alkoxysubstituiertes Aryl, wie Methoxyphenyl, halogen-(wie z.B. F, Cl, Br, J, vorzugsweise Cl-, Br-)-substituiertes Aryl, insbesondere Phenyl, wie z.B. p-Chlorphenyl;

oder $R^1$ zusammen mit $R^2$, $R^1$ zusammen mit $R^3$ oder $R^2$ zusammen mit $R^3$ einen fünf- oder sechsgliedrigen Ring bilden kann;

$R^4$ und $R^5$ können untereinander gleich oder verschieden sein und für Alkyl, beispielsweise n-Alkyl mit 1 bis 4 Kohlenstoffatomen, wie Methyl und Ethyl, sek.Alkyl mit 3 bis 5 Kohlenstoffatomen, wie z.B. Isopropyl, tert.-Alkyl mit 4 bis 5 Kohlenstoffatomen, wie tert.Butyl, Cycloalkyl, wie Cyclohexyl oder Aralkyl mit 1 bis 2 Kohlenstoffatomen in der Alkylgruppe, wie z.B. Benzyl oder $R^4$ und $R^5$ sind miteinander unter Bildung eines fünf- oder sechsgliedrigen Ringes verbunden, beispielsweise:

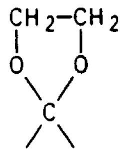 , 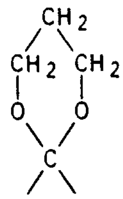 , 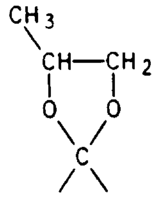 oder 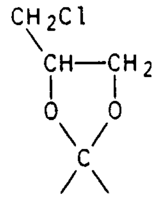

Beispiele geeigneter Monoketale von $\beta$-Dicarbonylverbindungen sind:

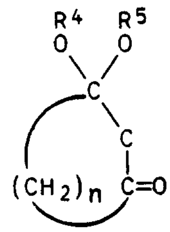 n = 2 oder 3 , 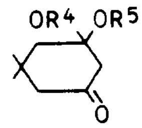 ,

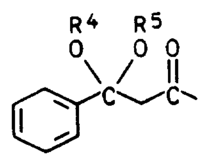 , 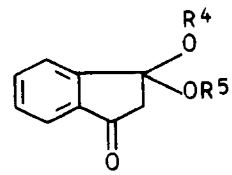 und

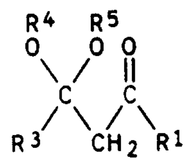

$R^1 = R^3$ = Ethyl,
worin jeweils $R^4$ und $R^5$ für $CH_3$ oder $C_2H_5$ stehen oder $R^4$ mit $R^5$ zu einer $-CH_2-CH_2-$ , $-CH_2-CH_2-CH_2-$ ,

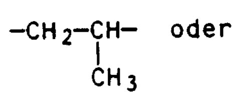 oder 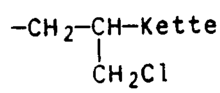

verbunden ist.

Auch Gemische der obengenannten monoketalisierten $\beta$-Diketone können eingesetzt werden. Die monoketalisierten $\beta$-Diketone (c) sind im erfindungsgemäßen strahlungsempfindlichen Gemisch im allgemeinen in Mengen von 3 bis 35, vorzugsweise 10 bis 25 Gew.%, bezogen auf die Gesamtmenge des Gemisches aus (a), (b) und (c) vorhanden.

Das erfindungsgemäße strahlungsempfindliche Gemisch kann zusätzlich noch weitere übliche Hilfs- und Zusatzstoffe enthalten.

Die erfindungsgemäßen Gemische werden bevorzugt in einem organischen Lösungsmittel gelöst, wobei der Feststoffgehalt im allgemeinen im Bereich zwischen 5 und 40 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone, wie beispielsweise Cyclohexanon, Cyclopentanon und Methyl-ethyl-keton, sowie Acetate wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind hierfür bevorzugt, jedoch können auch andere Farbstoffe, die als Sensibilisatoren wirken, verwendet werden.

Bei dem erfindungsgemäßen Verfahren zur Herstellung von Reliefmustern wird eine strahlungsempfindliche Aufzeichnungsschicht, die im wesentlichen aus dem erfindungsgemäßen strahlungsempfindlichen Gemisch besteht, bildmäßig in solcher Dosis bestrahlt, daß die Löslichkeit der belichteten Bereiche in wäßrig-alkalischen Lösungsmitteln zunimmt und diese bestrahlten Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 130 °C) und mit einer geeigneten Lichtquelle durch eine Photomaske bildmäßig belichtet. Als Lichtquellen eignen sich insbesondere kurzwellige UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 150 °C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 80 und 250 mj/cm$^2$ bei Schichtdicken von 1 µm.

Die in den Beispielen angegebenen Teile und Prozente sind, soweit nicht anders angegeben, Gewichtsteile bzw. Gewichtsprozente.

Beispiel 1

Eine Photoresistlösung wird aus 80 Teilen eines Novolaks auf Basis von Kresol-Formaldehyd mit einem mittleren Molekulargewicht $\overline{M}_n$ von 350 g/mol, 5 Teilen Triphenylsulfoniumhexafluoroarsenat, 15 Teilen 3-Ethylenketal-5,5-dimethylcyclohexanon und 250 Teilen Ethylenglykol-monomethyletheracetat hergestellt.

Die Lösung wird anschließend durch ein Filter mit einem Porendurchmesser von 0,2 µm filtriert.

Die Resistlösung wird auf einen Siliciumwafer, der mit Hexamethyldisilazan als Haftvermittler überzogen ist, mit 4000 Upm/30 Sekunden aufgeschleudert, wobei eine Schichtdicke von etwa 1 µm erhalten wird. Der Wafer wird während 3 Minuten auf einer Heizplatte bei 80 °C getrocknet, anschließend mit einer bildmäßig strukturierten Testmaske in Kontakt gebracht und mit einem Excimer-Laser ($\lambda$ = 248 nm, E = 35 mW/cm$^2$) belichtet. Danach wird der Wafer 1 Minute bei 80 °C ausgeheizt und mit einem Entwickler vom pH-Wert 12,0-13,6 entwickelt. Die Lichtempfindlichkeit beträgt 250 mJ/cm$^2$.

Beispiel 2

Eine Photoresistlösung wird durch Mischen von
25 Teilen Novolak (MG = 350 g/mol)
40 Teilen Poly-(p-hydroxystyrol) (Handelsprodukt von Polysciences INC, MG = 1500-1700)
10 Teilen Triphenylsulfoniumhexafluoroarsenat (Handelsprodukt der Fa. ALFA)
25 Teilen 3-Ethylenketal-5,5-dimethylcyclohexanon und
250 Teilen Ethylenglykol-mono-methyletheracetat
hergestellt und wie in Beispiel 1 beschrieben weiterverarbeitet. Man erhält eine Lichtempfindlichkeit = 100 mJ/cm$^2$.

Beispiel 3

Eine Photoresistlösung aus
80 Teilen Novolak (MG = 350 g/mol)
5 Teilen Triphenylsulfoniumhexafluoroarsenat
15 Teilen 3-Ethylenketal-cyclohexanon
250 Teilen Ethylenglykol-mono-methyletheracetat
wird analog Beispiel 1 weiterverarbeitet. Man erhält eine Lichtempfindlichkeit = 220 mJ/cm$^2$.

Beispiel 4

Eine Photoresistlösung wird durch Mischen von
30 Teilen Novolak (MG = 350 g/mol)
40 Teilen Poly-(p-hydroxystyrol)
5 Teilen Triphenylsulfoniumhexafluoroarsenat
25 Teilen 5-Ethylenketal-3-heptanon
250 Teilen Ethylenglykol-mono-methyletheracetat
wird analog Beispiel 1 auf einen Siliciumwafer aufgetragen und wie in Beispiel 1 weiterbehandelt. Lichtempfindlichkeit: 150 mJ/cm$^2$.

**Patentansprüche**

1. Strahlungsempfindliches Gemisch, im wesentlichen bestehend aus
   (a) einem in Wasser unlöslichen, in wäßrig-alkalischen Lösungen löslichen Bindemittel oder Bindemittelgemisch,
   (b) einer bei Bestrahlung eine starke Säure bildenden Verbindung und
   (c) einer oder mehreren die Löslichkeit von (a) in wäßrig-alkalischen Lösungen inhibierenden organischen Verbindungen,

   dadurch gekennzeichnet, daß die organische Verbindung (c) ein Monoketal einer $\beta$-Dicarbonylverbindung der allgemeinen Formel (I)

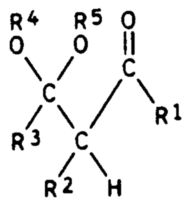

(I)

   ist, worin

   $R^1$ und $R^3$ untereinander gleich oder verschieden sind und für Alkyl, Cycloalkyl, Aralkyl, gegebenenfalls alkyl- oder halogensubstituiertes Aryl stehen,

   $R^2$ = Wasserstoff, Halogen, Alkyl, Cycloalkyl, Aralkyl, gegebenenfalls alkyl- oder halogensubstituiertes Aryl,

   oder $R^1$ zusammen mit $R^2$, $R^1$ zusammen mit $R^3$ oder $R^2$ zusammen mit $R^3$ einen fünf- oder sechsgliedrigen Ring bilden,
   $R^4$ und $R^5$ untereinander gleich oder verschieden sind und für Alkyl, Cycloakyl oder Aralkyl stehen, oder $R^4$ und $R^5$ zusammen einen fünf- oder sechsgliedrigen Ring bilden.

2. Strahlungsempfindliches Gemisch nach Anspruch 1, dadurch gekennzeichnet, daß als Bindemittel (a) ein phenolisches Harz eingesetzt wird.

3. Strahlungsempfindliches Gemisch nach Anspruch 2, dadurch gekennzeichnet, daß als phenolisches Harz ein Novolak mit einem mittleren Molekulargewicht $\overline{M}_n$ zwischen 300 und 20.000 eingesetzt wird.

4. Strahlungsempfindliches Gemisch nach Anspruch 1, dadurch gekennzeichnet, daß als Bindemittel (a) Poly(p-hydroxystyrol), Poly(p-hydroxy-$\alpha$-methylstyrol) oder Copolymerisate aus p-Hydroxystyrol und p-tert.-Butoxycarbonyloxistyrol, p-Hydroxystyrol und Alkoxystyrol oder p-Hydroxystyrol und 2-Tetrahydropyranyloxistyrol eingesetzt wird.

5. Strahlungsempfindliches Gemisch nach Anspruch 1, dadurch gekennzeichnet, daß als Bindemittel (a) ein Gemisch aus einem Novolak mit einem mittleren Molekulargewicht $\overline{M}_n$ zwischen 300 und 20.000 und Poly(p-hydroxystyrol) eingesetzt wird.

6. Strahlungsempfindliches Gemisch nach einem der vorhergehenden Ansprüche, dadurch gekennzeichnet, daß als bei Bestrahlung eine starke Säure bildende Verbindung (b) ein Sulfoniumsalz der allgemeinen Formel (II)

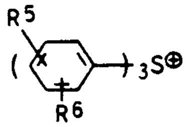 $X^\ominus$ (II)

eingesetzt wird, worin $R^5$ und $R^6$ untereinander gleich oder verschieden sind und für H, OH oder einen der Reste

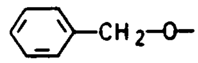 ,

($C_1$- bis $C_4$-Alkyl)$_3$Si-O- ,

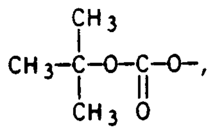

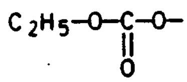 oder 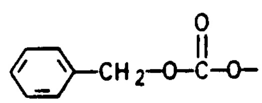

stehen und $X^\ominus$ = $Cl^\ominus$, $Br^\ominus$, $ClO_4^\ominus$, Hexafluoroarsenat, Hexafluoroantimonat, Hexafluorophosphat und/oder Tetrafluoroborat ist.

**7.** Strahlungsempfindliches Gemisch nach Anspruch 6, dadurch gekennzeichnet, daß als bei Bestrahlung eine starke Säure bildende Verbindung (b) anstelle des Sulfoniumsalzes der allgemeinen Formel (II) ein Iodoniumsalz der allgemeinen Formel (III)

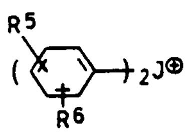 $X^\ominus$ (III),

worin $R^5$, $R^6$ und $X^\ominus$ die in Anspruch 6 angegebene Bedeutung haben, eingesetzt wird.

**8.** Strahlungsempfindliches Gemisch nach einem der vorhergehenden Ansprüche, dadurch gekennzeichnet, daß als Monoketal einer $\beta$-Dicarbonylverbindungder allgemeinen Formel (I) ein Monoketal von 1,3-Cyclohexandion, ein Monoketal von 1,3-Cyclopentandion, ein Monoketal von Dimedon, ein Monoketal von 1,3-Indandion oder ein Monoketal von Benzoylaceton eingesetzt wird.

**9.** Verfahren zur Herstellung von Reliefstrukturen oder zur Strukturierung von Wafern durch Auftragen von Photoresistlösungen in einer Schichtdicke von 0,1 bis 5 $\mu$m auf ein in üblicher Weise vorbehandeltes Substrat, Trocknen, bildmäßige Belichtung, gegebenenfalls Erhitzen auf Temperaturen von bis zu 150 °C, und Entwickeln mit einer wäßrig-alkalischen Lösung, dadurch gekennzeichnet, daß Photoresistlösungen eingesetzt werden, die strahlungsempfindliche Gemische gemäß einem der Ansprüche 1 bis 8 enthalten.

## Claims

**1.** A radiation-sensitive mixture consisting essentially of

(a) a binder or binder mixture which is insoluble in water but soluble in aqueous alkali,
(b) a compound which on irradiation forms a strong acid, and
(c) one or more organic compounds which inhibit the solubility of (a) in aqueous alkali,

wherein organic compound (c) is a monoketal of a $\beta$-dicarbonyl compound of the general formula (I)

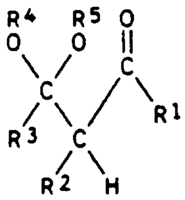

(I)

where

$R^1$ and $R^3$, which may be identical to or different from each other, are each alkyl, cycloalkyl, aralkyl or unsubstituted or alkyl- or halogen-substituted aryl, and

$R^2$ is hydrogen, halogen, alkyl, cycloalkyl, aralkyl or unsubstituted or alkyl- or halogen-substituted aryl,

or $R^1$ together with $R^2$, $R^1$ together with $R^3$ or $R^2$ together with $R^3$ form a five- or six-membered ring,

$R^4$ and $R^5$, which may be identical to or different from each other, are each alkyl, cycloalkyl or aralkyl, or $R^4$ and $R^5$ together form a five- or six-membered ring.

**2.** A radiation-sensitive mixture as claimed in claim 1, wherein binder (a) is a phenolic resin.

**3.** A radiation-sensitive mixture as claimed in claim 2, wherein the phenolic resin is a novolak having an average molecular weight $M_n$ of from 300 to 20,000.

**4.** A radiation-sensitive mixture as claimed in claim 1, wherein binder (a) is poly(p-hydroxystyrene), poly-(p-hydroxy-$\alpha$-methylstyrene) or a copolymer of p-hydroxystyrene and p-tert-butoxycarbonyloxystyrene, p-hydroxystyrene and alkoxystyrene, or p-hydroxystyrene and 2-tetrohydropyranyloxystyrene.

**5.** A radiation-sensitive mixture as claimed in claim 1, wherein binder (a) is a mixture of a novolak having an average molecular weight $M_n$ of from 300 to 20,000 and poly(p-hydroxystyrene).

**6.** A radiation-sensitive mixture as claimed in any of the preceding claims, wherein compound (b) which on irradiation forms a strong acid is a sulfonium salt of the general formula (II)

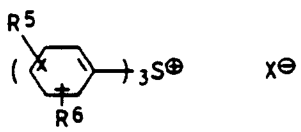

(II)

where $R^5$ and $R^6$, which may be identical to or different from each other, are each H, OH or one of the radicals

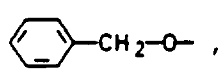

$(C_1\text{- to } C_4\text{-alkyl})_3Si\text{-O-}$,

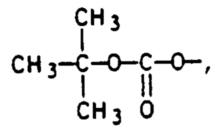

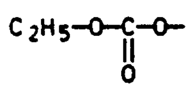

or

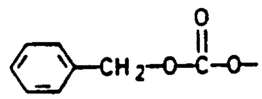

and $X^{\ominus}$ is $Cl^{\ominus}$, $Br^{\ominus}$, $ClO_4^{\ominus}$, hexafluoroarsenate, hexafluoroantimonate, hexafluorophosphate or tetrafluoroborate.

**7.** A radiation-sensitive mixture as claimed in claim 6, wherein compound (b) which on irradiation form a strong acid is not a sulfonium salt of the general formula (II) but an iodonium salt of the general formula (III)

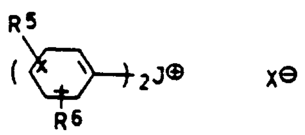

(III)

where $R^5$, $R^6$ and $X^{\ominus}$ are each as defined in claim 6.

**8.** A radiation-sensitive mixture as claimed in any of the preceding claims, wherein the monoketal of the $\beta$-dicarbonyl compound of the general formula (I) is a monoketal of 1,3-cyclohexanedione, a monoketal of 1,3-cyclopentanedione, a monoketal of dimedone, a monoketal of 1,3-indandione or a monoketal of benzoylacetone.

**9.** A process for producing a relief structure, or for structuring a wafer, by applying a photoresist solution in a layer thickness of from 0.1 to 5 µm to a conventionally pretreated substrate, drying, subjecting to imagewise exposure with or without heating at up to 150 °C, and developing with an aqueous alkali, which comprises using a photoresist solution which contains a radiation-sensitive mixture as claimed in any of claims 1 to 8.

## Revendications

**1.** Mélange sensible aux rayonnements, consistant essentiellement en :

a) un liant ou mélange de liants insoluble dans l'eau mais soluble dans les solutions aqueuses alcalines,

b) un composé formant un acide fort à l'irradiation, et

c) un ou plusieurs composés organiques inhibant la solubilité de (a) dans les solutions aqueuses alcalines,

caractérisé en ce que le composé organique c) est un monoacétal d'un dérivé $\beta$-dicarbonylé de formule générale I

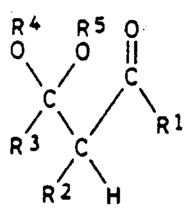

(I)

dans laquelle
$R^1$ et $R^3$, ayant des significations identiques ou différentes, représentent chacun un groupe alkyle, cycloalkyle, aralkyle, un groupe aryle éventuellement substitué par des groupes alkyle ou des halogènes,
$R^2$ représente l'hydrogène, un halogène, un groupe alkyle, cycloalkyle, aralkyle ou un groupe aryle éventuellement substitué par des groupes alkyle ou des halogènes,
ou bien $R^1$ forme avec $R^2$, $R^1$ forme avec $R^3$ ou $R^2$ forme avec $R^3$ un cycle à 5 ou 6 chaînons,
$R^4$ et $R^5$, ayant des significations identiques ou différentes, représentent chacun un groupe alkyle, cycloalkyle ou aralkyle, ou bien $R^4$ et $R^5$ forment ensemble un cycle à 5 ou 6 chaînons.

**2.** Mélange sensible aux rayonnements selon la revendication 1, caractérisé en ce que le liant a) est une résine phénolique.

**3.** Mélange sensible aux rayonnements selon la revendication 2, caractérisé en ce que la résine phénolique est une novolaque de poids moléculaire moyen $\overline{M}n$ compris entre 300 à 20 000.

**4.** Mélange sensible aux rayonnements selon la revendication 1, caractérisé en ce que le liant a) consiste en poly-(p-hydroxystyrène), un poly-(p-hydroxy-α-méthylstyrène), ou un copolymère du p-hyroxystyrène et du p-tert-butoxycarbonyloxystyrène, du p-hydroxystyrène et d'un alcoxystyrène ou du p-hydroxystyrène et du 2-tétrahydropyrannyloxystyrène.

**5.** Mélange sensible aux rayonnements selon la revendication 1, caractérisé en ce que le liant a) est un mélange d'une novolaque de poids moléculaire moyen $\overline{M}n$ compris entre 300 à 20 000 et de poly-(p-hydroxystyrène).

**6.** Mélange sensible aux rayonnements selon l'une des revendications qui précèdent, caractérisé en ce que le composé b) formant un acide fort à l'irridiation est un sel de sulfonium de formule générale I

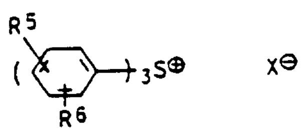 (II)

dans laquelle $R^5$ et $R^6$, ayant des significations identiques ou différentes, représentent chacun H, OH ou l'un des groupes

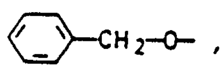

(alkyle en $C_1$-$C_4$)$_3$Si-O-,

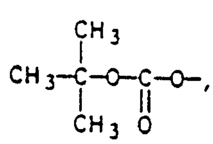

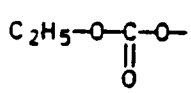 ou 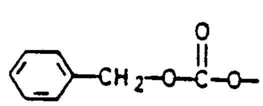

et $X^{\ominus}$ = $Cl^{\ominus}$, $Br^{\ominus}$, $ClO_4{}^{\ominus}$, hexafluoroarséniate, hexafluoroantimoniate, hexafluorophophate et/ou tétrafluoroborate.

**7.** Mélange sensible aux rayonnements selon la revendication 6, caractérisé en ce que l'on utilise en tant que composé b) formant un acide fort à l'irradiation, à la place du sel de sulfonium de formule générale II, un sel d'iodonium de formule générale III

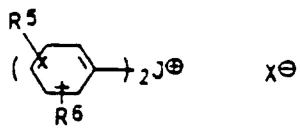

(III),

dans laquelle $R^5$, $R^6$ et $X^{\ominus}$ ont les significations indiquées dans la revendication 6.

**8.** Mélange sensible aux rayonnements selon l'une des revendications qui précèdent, caractérisé en ce que le monoacétal de dérivé $\beta$-dicarbonylé de formule générale I est un monoacétal de la 1,3-cyclohexane-dione, un monoacétal de la 1,3-cyclopentane-dione, un monacétal du Dimedon, un monoacétal de la 1,3-indane-dione ou un monoacétal de la benzoylacétone.

**9.** Procédé pour former des structures en relief ou pour structurer des plaquettes par application de solutions de photoréserve à une épaisseur de couche de 0,1 à 5 µm sur un support traité au préalable de la manière habituelle, séchage, exposition à la lumière avec formation d'une image, le cas échéant chauffage à des températures allant jusqu'à 150 ° C, et développement à l'aide d'une solution aqueuse alcaline, caractérisé en ce que l'on utilise des solutions de photoréserve contenant des mélanges sensibles aux rayonnements selon l'une des revendications 1 à 8.